(19) Europäisches Patentamt
European Patent Office
Office européen des brevets

(11) **EP 1 869 779 B1**

(12) **EUROPEAN PATENT SPECIFICATION**

(45) Date of publication and mention
of the grant of the patent:
**10.04.2013 Bulletin 2013/15**

(51) Int Cl.:
*H04B 1/10* (2006.01)          *H04B 7/00* (2006.01)
*H04B 1/69* (2011.01)          *H03D 3/00* (2006.01)
*H04L 27/06* (2006.01)

(21) Application number: **06736197.2**

(22) Date of filing: **27.02.2006**

(86) International application number:
**PCT/US2006/006821**

(87) International publication number:
**WO 2006/101672 (28.09.2006 Gazette 2006/39)**

(54) **RECEIVER FOR RECEIPT AND DEMODULATION OF A FREQUENCY MODULATED RF SIGNAL AND METHOD OF OPERATION THEREIN**

EMPFÄNGER ZUM EMPFANG UND ZUR DEMODULIERUNG EINES FREQUENZMODULIERTEN RF-SIGNALS UND BETRIEBSVERFAHREN DAFÜR

RECEPTEUR DE RECEPTION ET DE DEMODULATION D'UN SIGNAL RF A MODULATION DE FREQUENCE ET PROCEDE DE MISE EN OEUVRE

(84) Designated Contracting States:
**AT BE BG CH CY CZ DE DK EE ES FI FR GB GR HU IE IS IT LI LT LU LV MC NL PL PT RO SE SI SK TR**

(30) Priority: **18.03.2005 GB 0505493**

(43) Date of publication of application:
**26.12.2007 Bulletin 2007/52**

(73) Proprietor: **Motorola Solutions, Inc.**
**Schaumburg IL 60196 (US)**

(72) Inventors:
• **BEN-AYUN, Moshe,**
**67899 Tel Aviv (IL)**
• **ROZENTAL, Mark,**
**67899 Tel Aviv (IL)**
• **CORSE, Nir,**
**67899 Tel Aviv (IL)**
• **GROSSMAN, Ovadia,**
**67899 Tel Aviv (IL)**

(74) Representative: **Treleven, Colin et al**
**Optimus Patents Limited**
**Grove House**
**Lutyens Close**
**Basingstoke**
**Hampshire, RG24 8AG (GB)**

(56) References cited:
GB-A- 2 349 313          US-A- 5 422 880
US-A- 5 598 125          US-A1- 2003 203 728
US-A1- 2004 014 450      US-B1- 6 608 999

**Description**

**FIELD OF THE INVENTION**

The present invention relates to a receiver for receipt and demodulation of a frequency modulated (FM) signal and a method of operation therein. In particular, the invention relates to a receiver which operates by a direct conversion procedure in which a received FM signal is down-converted directly to a baseband signal.

**BACKGROUND OF THE INVENTION**

Conventional FM receivers have a problem when built using direct conversion architectures. Residual DC offset that is caused by operation of the receiver hardware components adds to the input signal and causes an undesirable distortion in the output, e.g. in the form of an audible signal, provided to a user. The residual DC offset is caused for example by radiation from the local oscillator in the mixers of the receiver, and by DC imbalances in the amplifiers of the receiver.

In the prior art, the problem has not been dealt with satisfactorily. A one-off correction has been applied, e.g. during factory production. However, the DC offset can vary with time, e.g. as a result of changes in temperature. Thus, the one-off correction can become ineffective with time, particularly if a low tolerance of the DC offset is to be accepted. For example, in some receivers a maximum residual DC offset level of $10\mu V$ needs to be achieved whereas the DC offset level present may be as high as $200\mu V$.

US6608999 discloses a direct conversion RF receiver. I and Q signals are provided in separate paths. An offset compensation circuit in each path provides a moving average of each signal, which is subtracted from the signal. Once the moving average value has been determined, it is fed back to components located prior to a digital filter in each path, so that each digital filter can be fed with the average value. This allows receiver circuits to be switched off immediately after the average value determination, in order to save power, but without generating noise in the digital filter. US2004/0014450 discloses a direct conversion RF receiver. I and Q signals are provided in separate paths. A compensator compensates for a DC offset in the input signal.

**SUMMARY OF THE INVENTION**

According to the present invention in a first aspect there is provided a receiver for receiving and demodulating a tone frequency modulated RF signal by a direct conversion procedure, the receiver being as defined in claim 1 of the accompanying claims.

The present invention provides an improved FM receiver in which the problem of undesirable DC offset described above in the receiver is reduced or eliminated. The DC offset may be estimated, in repeated runs of an estimation procedure, by performing a calculation, preferably continuously, by an estimator to estimate the level of DC offset present and by applying a correction using an adjustment signal to cancel the estimated DC offset. Preferably, the calculation and correction are applied using an estimator in each of an I-channel and a Q-channel of the receiver. The calculation performed by the estimator includes (i) taking a set of N samples of the value of an input signal component in the respective channel; (ii) summing the values obtained for the N samples; and (iii) calculating an average value by dividing the sum by the number N of samples.

Advantageously, the receiver may include a detector which calculates a value of a parameter that is related to a frequency offset between a carrier frequency (centre frequency) of a received FM input signal and a reference frequency of a local oscillator of the receiver. The detector may determine whether the value exceeds a pre-determined threshold. The threshold may indicate that the offset frequency is close to zero or an integral multiple of the frequency of a carried information signal (e.g. an audio or sub-audio signal). The carried signal may beneficially be a known tone frequency as described later. Where the detector determines that the calculated value is greater than the threshold, a controller associated with the detector may increase a sampling (integration) time of the estimator(s) employed to estimate a component of DC offset. Where the sampling time reaches a pre-determined maximum value, the controller may issue a signal which causes the frequency of the reference frequency signal produced by the local oscillator to be shifted by an amount equivalent to half the frequency of an information signal, e.g. audio or sub-audio signal or tone of known frequency, carried by the received input signal.

The receiver and method according to the invention allow DC receiver offset to be estimated and compensated for frequently or continuously, whilst a FM input signal is being received at the input terminal of the receiver, and without distorting the signal being demodulated, thereby beneficially allowing distortion caused by such DC offset to be suitably minimised or eliminated, thereby improving the quality of a signal provided as an output, e.g. as speech or data information, to a user.

Embodiments of the present invention will now be described by way of example with reference to the accompanying drawings, in which:

## BRIEF DESCRIPTION OF THE DRAWINGS

FIG. 1 is a schematic block circuit diagram of a known FM receiver.
FIG. 2 is a schematic block circuit diagram of an FM receiver embodying the invention.
FIG. 3 is a graph of detector output versus offset frequency for a detector employed in the receiver of FIG. 2.
FIG. 4 is a flowsheet illustrating an operational procedure employed in the receiver of FIG. 2.

## DESCRIPTION OF EMBODIMENTS OF THE INVENTION

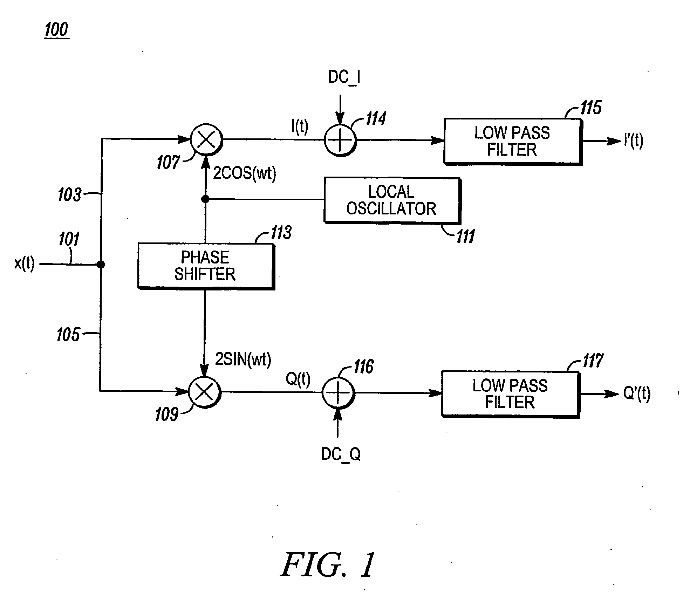

FIG. 1 shows a known RF direct conversion FM receiver 100 illustrating the problem to be addressed by the present inventions. An incoming FM signal $x(t)$ is delivered via an input path 101 having branched connections 103, 105 respectively to two mixers 107, 109. A local oscillator 111 generates a reference signal intended to have the same frequency as the carrier frequency of the incoming signal $x(t)$. A first component of the reference signal is applied directly to the mixer 107 where it is multiplied with the input signal $x(t)$. A second component of the reference signal is applied to a phase shifter 113. An output of the phase shifter 113 which is the reference signal shifted in phase by ninety degrees is applied to the mixer 109. The respective outputs of the mixers 107, 109 are an in-phase component $I(t)$ and a quadrature phase component $Q(t)$ of the input signal $x(t)$. The receiver 100 generates a residual DC offset as described earlier and this is shown adding to the components $I(t)$ and $Q(t)$ as components $DC\_I$ and $DC\_Q$ at junctions 114 and 116 respectively. The components $I(t)$ and $Q(t)$ added respectively to the DC offset components $DC\_I$ and $DC\_Q$ are applied to low pass filters 115 and 117. The output signal components from the low pass filters 115 and 117, denoted respectively as $I'(t)$ ($I(t) + DC\_I$) and $Q'(t)(Q(t)+DC\_Q)$ are further processed, e.g. in a manner to be described later, to obtain a demodulated signal.

The branched connections 103, 105 and the components included in them thus form respectively an I-channel and a Q-channel.

A mathematical analysis of operation of the receiver 100 shown in FIG. 1 is as follows:

The input signal $x(t)$ can be represented in a conventional manner as:

$$x(t) = \cos(wt + \phi(t) + \gamma) \qquad \text{(Equation 1)}$$

where $w$ is RF carrier angular frequency, $\gamma$ is oscillator arbitrary phase, and $\phi(t)$ *is* frequency modulation.
The output components $I'(t)$ and $Q'(t)$ are as follows:

$$I'(t) = DC\_I(t) + 2\cos(wt + \phi(t) + \gamma)\cos(wt) =$$
$$DC\_I(t) + \cos(2wt + \phi(t) + \gamma) + \cos(\phi(t) + \gamma) \underset{\substack{after \\ LPF}}{=} DC\_I(t) + \cos(\phi(t) + \gamma)$$

(Equation 2)

$$Q'(t) = DC\_Q(t) + 2A\cos(wt + \phi(t) + \gamma)\sin(wt) =$$
$$= DC\_Q(t) + A\sin(2wt + \phi(t) + \gamma) + A\sin(\phi(t) + \gamma) =$$
$$\underset{\substack{after \\ LPF}}{=} DC\_Q(t) + A\sin(\phi(t) + \gamma)$$

(Equation 3)

For tone FM modulation, explained below, the following simplification can be applied:

$$\phi(t) = 2\pi f_d \int_0^t A_m \cos(\omega_m \tau) d\tau = \beta \sin(\omega_m t)$$

where $\beta = \dfrac{A_m f_d}{f_m}$ is a modulation index, $A_m$ is the amplitude of the modulating tone (signal), $f_m$ is the frequency of the modulating tone, and $f_d$ is the FM deviation.

For the I channel with tone FM modulation:

$$I'(t) \approx DC\_I(t) + J_o(\beta) + 2\sum_{k=1}^{\infty} J_k(\beta)\cos(2k\omega_m t)$$

(Equation 4)

where $J$ represents a Bessel function.

For the Q channel with tone FM modulation:

$$Q'(t) \approx DC\_Q(t) + 2\sum_{k=1}^{\infty} J_{2k-1}(\beta)\sin((2k-1)\omega_m t)$$

(Equation 5)

The prior art approach for removing the DC offset in an FM direct conversion receiver is a one-off estimation of the value of the offset and application of an adjustment voltage. However, from the above Equation 4 for the tone FM modulation example, we can see that there is a problem with this approach: removing DC will remove $J_o(\beta)$ which is a DC component of the modulating information signal and will thereby introduce distortion in an output signal, e.g. an output audio signal such as speech.

The tone modulation example referred to above assumes use of a signalling tone (audio signal of known frequency carried as a modulation signal) at a frequency $f_m$ that provides frequency modulation in accordance with the industry standard TIA 603. This is an industry standard published by TIA and entitled 'Land Mobile FM OR PM Communications Equipment and Performance Standards'. The standard includes the following specification details: 'The CDCSS (Continuous Digital Controlled Squelch System) shall define a system where the radio receiver(s) are equipped with tone or data responsive devices that allow audio signals to appear at the receiver audio output, select voice processing such as scrambling, select between voice or data, or control repeater functions, only when a carrier modulated with a specific tone or data pattern is received. The tone or data pattern must be continuously present for continuous audio output. The transmitter emitting the carrier shall be modulated with a continuous tone as in a CTCSS system (Continuous Tone Controlled Squelch System), whose frequency is the same as the tone required to operate the tone-responsive CTCSS device at the receiver output. In a CDCSS system, the transmitter emitting the carrier shall in a similar manner be modulated with a continuous NRZ FSK data stream having the correct pattern to operate the data sensitive detector at the receiver output. The purpose of the defined system is to minimize the annoyance of hearing communications directed to others sharing the same carrier frequency or channel. By using a specific tone or data stream, each user may code his carrier to prevent the reception of audio signals by any uncoded or differently coded carriers The CDCSS turn off code is the waveform necessary to disable the audio output of the receiver prior to the RF carrier removal. This serves as a squelch tail or noise eliminator. To accomplish this, the CDCSS encoder shall transmit a 134.4 +/-0.5 Hz tone for 150 to 200 milliseconds. It can also be a PL/DPL tone. (PL=Private Line, DPL=Digital Private Line)'.

CTCSS/CDCSS and PL/DPL is thus sub-audio signalling under known standard conditions using the protocol of the above TIA standard. PL/DPL tones are transmitted in parallel with voice. The TIA standard provides a list of suitable tone frequencies, e.g. at 67Hz and 71Hz for PL.

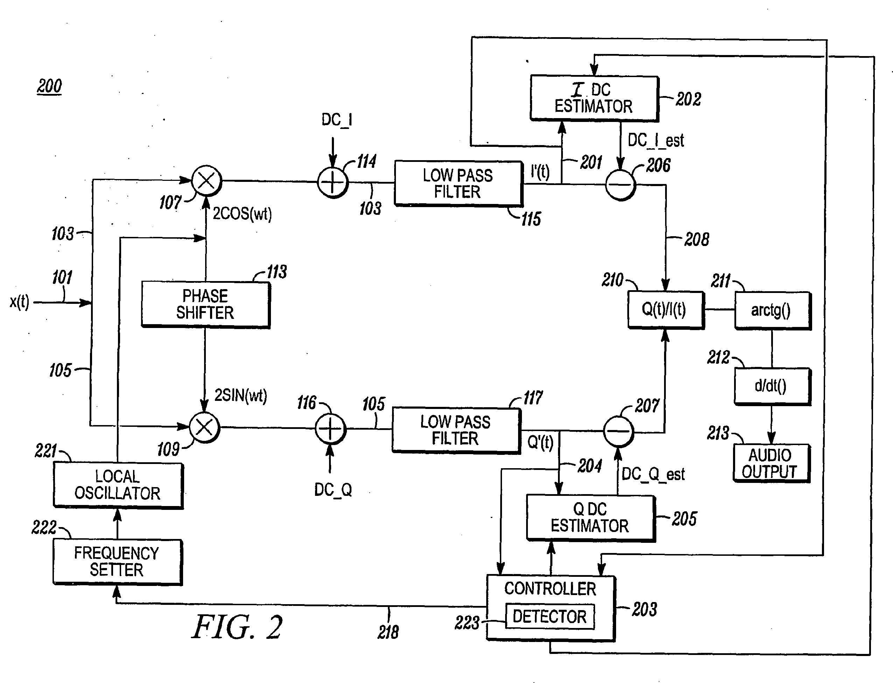

FIG. 2 shows a RF direct conversion FM receiver 200 embodying the present invention. Components which are the same as in FIG. 1 have the same reference numerals as in FIG. 1 and will not be further described. The receiver 200 operates using tone FM modulation as described earlier.

The local oscillator 111 of FIG. 1 is replaced in the receiver 200 of FIG. 2 by a local oscillator 221 which provides an output reference signal having a frequency which may be shifted by a frequency setter 222 in a manner described later.

The output signal *I'(t)* from the low pass filter 115 in the I-channel of the receiver 200 is delivered to a junction 206 and is sampled prior to the junction 206 by a connection 201. The connection 201 provides an input connection to an I DC estimator 202 and also to a controller 203 which incorporates a dual purpose offset frequency detector 223. Similarly, the output signal *Q'(t)* from the low pass filter 117 in the Q-channel is delivered to a junction 207 and is sampled prior to the junction 207 by a connection 204. The connection 204 provides an input connection to a Q DC estimator 205 and also to the controller 203. An output connection 218 from the controller 203 provides an input connection to the frequency setter 222.

The I DC estimator 202 estimates, using the sampled input from the connection 201 and also with reference to input signals from the controller 203, a value of *DC_I* in a manner to be described in detail later and applies at the junction 206 a microvoltage which effectively cancels the estimated DC offset component *DC_I*.

Similarly, the Q DC estimator 205 estimates, using the sampled input from the connection 204 and also with reference to input signals from the controller 203, a value of *DC_Q* in a manner to be described and applies at the junction 207 a microvoltage which effectively cancels the estimated DC offset component *DC_Q*.

The junction 206 provides in a connection 208 of the I-channel a corrected output signal *I(t)* from which the DC component *DC_I* has been removed. Likewise, the junction 207 provides in a connection 209 of the Q-channel a corrected output *Q(t)* from which the DC component *DC_Q* has been removed. These corrected outputs are applied to a processor 210 which calculates a value of the quotient *Q(t)/I(t)*. An output signal which represents the quotient value calculated by the processor 210 is passed to a processor 211 which calculates a value of the arctangent of the quotient represented by the signal input to the processor 211. An output signal from the processor 211 which represents the calculated arctangent value is passed to a further processor 212 which calculates the differential with respect to time, t, of the input signal to the processor 212 which represents the arctangent value calculated by the processor 211. Finally, a demodulated output signal is provided by the processor 212 and is provided to an audio output 213 which converts the output signal into an appropriate audio form, e.g. as speech.

It will be apparent to those skilled in the art that in practice a single processor device, e.g. in the form of a programmed digital signal microprocessor, may perform the functions of any two or more of the processors employed in the receiver 200 shown in FIG. 2, Such processors include the controller 203, detector 223, frequency setter 222 and the estimators 202 and 205 as well as the processors 210, 211 and 212.

Operation of the controller 203, the detector 223 and the estimators 202 and 205 will now be explained in detail.

Let us examine the equation for the signal *I'(t)*:

$$I'(t) \approx DC\_I(t) + J_o(\beta) + 2\sum_{k=1}^{\infty} J_k(\beta)\cos(2k\omega_m t)$$

(Equation 6)

DC_I(t) as noted earlier is the undesirable DC offset due to receiver hardware operation. $J_o(\beta)$ is the DC component of the FM modulating signal. This relationship is true if the receiver 200 is tuned (by providing a reference signal of suitable frequency by the local oscillator 221) to exactly the same frequency as the transmitter carrier frequency, i.e. there is no frequency error. In practice, there is always likely to be some finite frequency offset between the carrier frequency of the received FM signal and the frequency of the reference signal produced by the local oscillator 221. This offset can be as small as 0.1 Hz or as large as 500 Hz. We shall assume that there is frequency offset of $f_{offset}$ Hz. For a low RF input signal (-120 to -90 dBm) the DC offset due to receiver hardware is higher than the DC component due to modulation $J_o(\beta)$. So at low RF signal levels the DC offset due to hardware is more dominant in the form of undesired audio distortion.

In order to estimate accurately the DC offset component due to receiver hardware with a target accuracy of 10 $\mu$V we need the modulation DC component $J_o(\beta)$ to be less then 1 $\mu$V. For -60 dBm at the antenna the DC component due to modulation is 10000 uV (worst case example). So an attenuation of 80 dB is needed for this example. Then the expression for *I'(t)* will be:

$$I'(t) \approx DC\_I(t) + J_o(\beta)\cos(2\pi f_{offset}t) + 2\sum_{k=1}^{\infty} J_k(\beta)\cos(2k(\omega_m + 2\pi f_{offset}) + t)$$

(Equation 7)

With a frequency offset present the modulation 'DC component' $J_o(\beta)$ is now at a frequency $f_{offset}$ Hz offset from DC offset due to hardware to be estimated.

Estimation of the DC offset components due to hardware may be done by integrating or summing the values of $I'(t)$ and $Q'(t)$ obtained in a set of N discrete samples over a suitable integration or summing period and then calculating an average by dividing the sum obtained by dividing by the number N of samples. From the expression for $I(t)$ in Equation 7 above, we can see that if $f_{offset} = 0$ then $J_o(\beta)$ appears at zero frequency. If $f_{offset} = n \cdot f_{PL}$, where $n$ is a positive or negative integer, and $f_{PL}$ is used as $f_m$, then the Bessel component $J_n(\beta)$ will also appear at zero frequency. So if we integrate $I'(t)$ over a long enough period and if $J_n(\beta)$ is not at zero frequency offset, we will obtain only the required DC component at 0 Hz, namely the DC offset component due to hardware, $DC\_I(t)$.

However, in order to produce a correct DC estimation that will only include the component $DC\_I(t)$ the integration time (or number of samples for a given sampling frequency) needs to be adaptively controlled as a function of $f_{offset}$. This can be explained as follows. Integration is equivalent to low pass filtering. A longer integration time is equivalent to a low pass filter band that is narrower. A shorter integration time is equivalent to a low pass filter band that is wider. In our case we need an integration time to be long enough to eliminate the modulation 'DC' component $J_n(\beta)$ which is at a frequency $n f_{offset}$.

This integration procedure to produce an estimated value of $DC\_I(t)$, namely $DC\_I(t)\_est$, and of $DC\_Q(t)$, namely $DC\_Q(t)\_est$, can be summarized by the following equations:

$$DC\_I\_est = \frac{1}{N_{int}} \sum_i I(t_i) \quad \text{(Equation 8)}$$

and

$$DC\_Q\_est = \frac{1}{N_{int}} \sum_i Q(t_i) \quad \text{(Equation 9)}$$

where $T_{int} = \dfrac{N_{int}}{f_{sampling}}$

$T_{int}$ is the integration or averaging time and will be inversely proportional to the frequency offset $f_{offset}$, $N_{int}$ is the number of samples taken per set and $f_{sampling}$ is the sampling frequency. The controller 203 in FIG. 2 using calculations carried out by the detector 223 adaptively sets the integration time $T_{int}$ as explained later. If increasing the integration time does not help, the reference frequency produced by the local oscillator 111 will be shifted. The integration time should follow the following rule: $f_{PL} \cdot T_{int} = M$ or $f_{DPL} \cdot T_{int} = M$, where $M$ is an integer, $f_{PL}$ is the PL frequency and $f_{DPL}$ is the DPL frequency for tone FM modulation as defined earlier. This is so that the integration time is an integer multiple of the FM tone frequency, using PL or DPL.

The detector 223 which is incorporated in the controller 203 calculates a value of a parameter which is related to (an inverse function of) the offset frequency present between the received carrier signal and the reference signal produced by the local oscillator 221. If the detector 223 detects an offset frequency $f_{offset} = k \cdot fm$, where $k$ is zero or an integer, the controller 203 will issue a signal which will disable application of the correction estimated by the estimators 202 and 205.

Operation of the dual purpose offset frequency detector 203 is based on a modified correlation by operation of the following relationship (Equation 10):

$$Int = \frac{|\frac{1}{N}\sum_{n=0}^{N-1} I_r \cdot I_I|^2 + |\frac{1}{N}\sum_{n=0}^{N-1} Q_r \cdot Q_I|^2}{[I_r^2 + Q_r^2]^{3/2}}$$

where $I_I = \sin(\beta \cdot \sin(2 \cdot \pi \cdot f_{pl} t))$
$Q_I = \cos(\beta \cdot \sin(2 \cdot \pi \cdot f_{pl} t))$

Normalization by $[I_r^2 + Q_r^2]^{3/2}$ in Equation 10 has been applied so that the detector 223 will provide a higher output for a low RF input signal. Ir and Qr are received signals. $I_l$ and $Q_l$ are known real sample values stored in a memory incorporated within or associated with the controller 203 and detector 223 for each known received modulating frequency, e.g. for PL or DPL. For example, based on the expected PL/DPL frequency, the values of $I_l$ and $Q_l$ are stored in the memory.

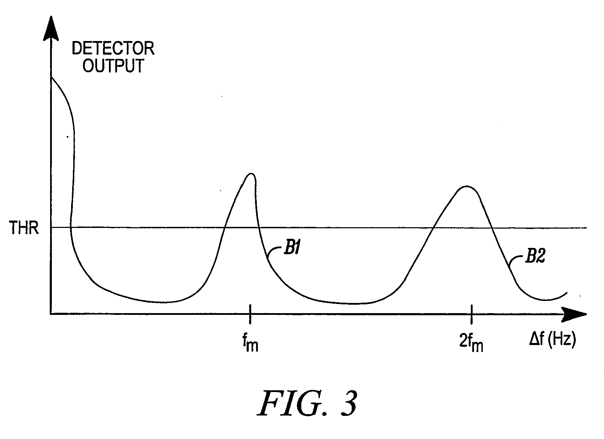

The output of the detector 223, which is the value of the parameter *Int* defined in Equation 10, as a function of offset frequency (Δf) for a received FM signal having a modulating signal frequency $f_m$, e.g. a PL or DPL tone, has a form shown in FIG. 3. Bands are obtained around offsets of $kf_m$, where k=0 or an integer. Typical bands around offsets of $f_m$ and $2f_m$, are indicated by reference indicators B1 and B2 in FIG. 3. The range of each problematic frequency offset in a band around $kf_m$ depends on the integration time operating in the detector 223. For example, for an integration time of 150 msec the problematic frequency range is $kf_m \pm 20Hz$. For an integration time of 2000 msec the problematic frequency range is $kf_m \pm 0.5Hz$. The detector 223 determines whether its output is within a problematic frequency band which contains a frequency $knf_m$ by determining whether the output calculated value of Int is greater than a pre-determined threshold value, THR.

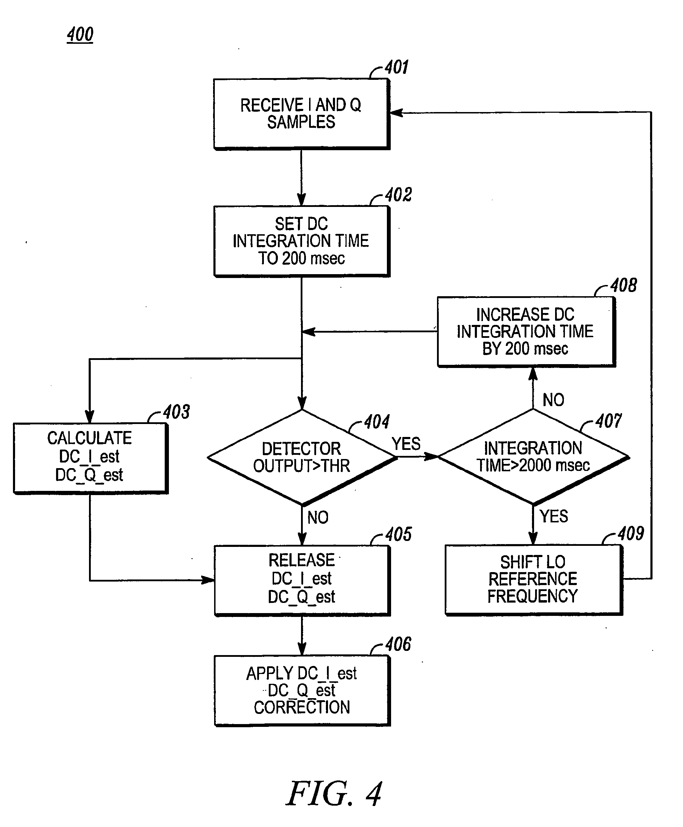

A preferred inventive procedure 400 (algorithm) which is employed by the controller 203 and detector 223 working in conjunction with the estimators 202 and 205 and the frequency setter 222, in the receiver 200 of FIG. 2 is represented by the flowsheet of FIG. 4. The procedure 400 operates as follows.

The procedure 400 begins with the receipt of samples of *I'(t)* and *Q'(t)* from the I-channel and the Q-channel respectively at a step 401. In a step 402, the controller 203 initially sets an integration time of 200 msec for use in the detector 223 and in the estimators 202 and 205. In a step 403, the estimators 202 and 205 sample and average *I'(t)* and *Q'(t)* in a set of N samples for an integration time, i.e. a sample set time, of 200 msec to obtain values of DC_I_est and DC_Q_est. At the same time, in a step 404, the detector 223 determines whether a calculated value of *Int* obtained from the detected frequency offset calculation as defined in Equation 10 earlier is greater than the threshold THR shown in FIG. 3. If the calculated value of *Int* is not greater than THR, the controller 203 sends a signal to the estimators 202 and 205 to release the DC estimated values, DC_I_est and DC_Q_est, calculated in step 403 for an integration time of 200 msec. So in a step 405 the values of DC_I_est and DC_Q_est are released as outputs from the estimators 202, 205 and are applied as voltage adjustments at the junctions 206, 207. These adjustments are subtracted respectively from *I'(t)* and *Q'(t)* in a step 406 to leave only the wanted signals *I(t)* and *Q(t)* as outputs in the I-channel and Q-channel respectively in the connections 208, 209.

If in step 404 the value of *Int* calculated by the detector 223 is greater than THR then no signal is issued by the controller 203 to proceed with the calculated values of DC_I_est and DC_Q_est. Instead, in a step 407, the controller 203 checks that the integration time used by the estimators 202, 205 has not yet reached 2000 msec and issues an instruction signal in a step 408 to the estimators 202, 205 to continue their integration (averaging) for another 200 msec. In addition, the detector 223 re-calculates the value of *Int* in step 403 applied again for another 200 msec - now totally for 400 msec. If, after those total 400 (200+200) msec, the value of *Int* is now less than THR, the controller 203 issues a signal in step 405 to the estimators 202, 205 to proceed to release the DC estimated values, DC_I_est and DC_Q_est, that they have calculated with the longer integration time of 400 msec, and these values are subtracted from I'(t) and Q'(t) respectively in step 406.

If in step 404 the detected value *Int* is still greater than THR then no signal is issued by the controller 203 to proceed with the calculated values of DC_I_est and DC_Q_est. Instead, step 407 is re-applied in which the controller 203 checks that the integration time used by the estimators 202, 205 and the detector 223 has not yet reached 2000 msec, and step 408 is re-applied in which the controller issues a signal to the estimators 202, 205 to continue their integration (averaging) for another 200 msec. The detector 223 re-calculates the value of *Int* in step 403 applied again for another 200 msec - now totally for 600 (200 + 200 + 200) msec. If, after that total period of 600 msec, the value of *Int* is now less than THR, the controller 203 issues a signal in step 405 to the estimators 202, 205 to proceed to release the DC estimated values, DC_I_est and DC_Q_est, that they have calculated and these values are subtracted from I'(t) and Q'(t) respectively in step 406. However, if after that period of 600 msec the values of *Int* is still greater than THR, then steps 407, 408 and 403 are re-applied, and so on.

Steps 407, 408 and 403 can be successively re-applied causing the integration time to be increased in steps of 200 msec, until a maximum integration time has been reached, e.g. 2000 msec. When the controller 203 determines in step 407 that the maximum integration time has been reached and a further increase would take the integration time above the maximum, the controller 203 issues a signal in a step 409 via the connection 218 to the frequency setter 222, to shift the frequency of the local oscillator 221 by $f_m/2$, in practice $F_{PL}/2$ or $F_{DPL}/2$ as appropriate. The procedure 400 then returns to step 401 and the controller 203 issues a signal for the integration time in the estimators 202, 205 and in the detector 223 to be re-set to 200 msec. The method then proceeds again using an integration time of 200 msec in the calculations carried out in step 403 and step 404.

Although the embodiments of the invention above have been described in terms of tone FM modulation, the use of tone FM modulation is to be regarded as illustrative rather than limiting.

Also, although the above embodiments have been described in terms of processing a signal to produce an audio output, the receiver described could also be used to process a signal producing another form of output for a user, e.g. a data output.

The circuits embodying the invention to compensate for receiver generated DC noise may be used in conjunction with other circuits used for making other corrections. For example, the FM receiver (e.g. receiver 200) may include circuit(s) (not shown) to compensate for phase imbalance and/or amplitude imbalance in the I and Q channels, e.g. as described in Applicant's copending UK patent applications GB 0411888.1 and GB 0414459.8.

**Claims**

1. A receiver (200) for receiving and demodulating a tone frequency modulated RF signal by a direct conversion procedure including an input signal path (101) for receiving an RF input signal and, connected to the input signal path, component channels (103, 105) for processing in-phase (1) and quadrature phase (Q) components of the input signal;
   wherein the receiver (200) further includes a compensator coupled to one of the component channels (103, 105) and configured to measure and compensate for DC offset produced by the receiver hardware and combined with an input signal component in the respective channel, the compensator including:

   an estimator (202, 205) operable to estimate a receiver hardware induced component of DC offset present in the one of the component channels (103, 105) by using an integration procedure calculated over an integration time period; and
   an estimator controller (203) operably coupled to the estimator (202, 205) and operable to:

   (i) calculate a first parameter, via an offset frequency detector (223) portion of the estimator controller (203), as an inverse function of a determined offset frequency present between a carrier frequency of the RF input signal and a locally generated reference signal;
   (ii) compare (404) the first parameter to a threshold value,
   (iii) if the first parameter is equal to or less than the threshold value, control (406) the estimator (202, 205) to compensate for the receiver hardware induced component of DC offset estimated over the integration time period; and
   (iv) if the first parameter is greater than the threshold value, control the estimator (202, 205) to temporarily suspend compensation for the receiver hardware induced component of DC offset, and instead re-estimate the receiver hardware induced component of DC offset using a second integration time period longer than the integration time period.

2. A receiver (200) according to claim 1, wherein the estimator (202, 205) is operable to estimate the receiver hardware induced component of the DC offset present in the one of the component channels by:

   (i) taking a set ofN samples of the value of the input signal component in the one of the component channels;
   (ii) summing the values obtained for the N samples; and
   (iii) calculating an average value by dividing the sum by the number N of samples, and wherein the receiver (200) further comprises a combiner operable to combine with the input signal component an adjustment signal which cancels the receiver hardware induced component of the DC offset present in the one of the component channels.

3. A receiver (200) according to claim 1 or claim 2, further comprising:

   an I-channel (103) connected to the input signal path (101) including a first mixer (107) for mixing the RF input signal with an in-phase reference signal to produce an in-phase component (I(t)) of the input signal in an I-channel;
   a Q-channel (105) connected to the input signal path (101) including a second mixer (109) for mixing the input signal with a quadrature-phase reference signal to produce a quadrature-phase component (*Q(t)*) of the input signal in the Q-channel;
   an I-channel compensator for measuring and compensating for a receiver hardware induced component of DC offset present in the I-channel combined with the input signal component in the I-channel; and
   a Q-channel compensator for measuring and compensating for a receiver hardware induced component of DC offset present in the Q-channel combined with the input signal component in the Q-channel.

**4.** A receiver (200) according to claim 3, wherein the I-channel compensator and the Q-channel compensator each include estimators (202, 205) which are operable to take a same number N of samples of the input signal components, in a given set of samples.

**5.** A receiver (200) according to claim 4, wherein the estimator (202, 205) of at least one of the I-channel compensator and the Q-channel compensator is operable to take a number N of samples in a set of samples which is variable from set-to-set.

**6.** A receiver (200) according to any previous claim, wherein:

the estimator controller (203) is operable to control (408) the integration time period used by the estimator (202, 205) to sample a set of values of the one of the component channels (103, 105); and
wherein the offset frequency detector (223) is operable, where an offset frequency is determined to be within a band which includes a frequency k. *fm*, where k is zero or an integer and *fm* is a modulating frequency of the input signal, to cause the estimator to issue a signal to suspend compensation for the receiver hardware induced component of DC offset, and instead re-estimate the receiver hardware induced component of DC offset using the second integration time period longer than the integration time period.

**7.** A receiver (200) according to claim 6, wherein
a value of the first parameter *Int* is given by:

$$Int = \frac{|\frac{1}{N}\sum_{n=0}^{N-1} I_r \cdot I_I|^2 + |\frac{1}{N}\sum_{n=0}^{N-1} Q_r \cdot Q_I|^2}{[I_r^2 + Q_r^2]^{3/2}}$$

for a set of N samples,
where $I_I = \sin(\beta \cdot \sin(2 \cdot \pi \cdot f_m \cdot t))$ and
$Q_I = \cos(\beta \cdot \sin(2 \cdot \pi \cdot f_m \cdot t))$,
where $I_r$ and $Q_r$ are received FM modulated signal quadrature components, and
where $I_I$ and $Q_I$ are component values stored in a memory associated with the detector, for a given received signal having a modulating frequency $_{fm}$ and a modulation index $\beta$.

**8.** A receiver (200) according to claim 7, wherein the estimator controller (203) is operable, if the first parameter is greater than the threshold value, to re-calculate the first parameter value after the increased integration time.

**9.** A receiver (200) according to claim 3, further comprising:

a local oscillator (221) for producing the reference signal and a phase shifter (113) connected to the local oscillator (221) for shifting phase of the reference signal to produce the quadrature phase reference signal and a frequency setter (222) for setting the frequency of the reference signal produced by the local oscillator (221), the frequency setter (222) being operable to vary the frequency of the reference signal; and
the estimator controller (203) operably coupled to the frequency setter (222), the offset detector operable to calculate the first parameter as an inverse function of a determined offset frequency present between the carrier frequency of the RF input signal and the reference signal and, where an offset frequency is determined to be within a band which includes a frequency k. *fm* where k is zero or an integer, and *fm* is a modulating frequency of the input signal, and the estimator controller (203) is operable to issue a signal to the frequency setter to shift the reference frequency to a frequency outside the band.

**10.** A receiver (200) according to claim 9, wherein:

a value of the first parameter *Int* is given by:

$$Int = \frac{|\frac{1}{N}\sum\limits_{n=0}^{N-1} I_r \cdot I_I|^2 + |\frac{1}{N}\sum\limits_{n=0}^{N-1} Q_r \cdot Q_I|^2}{[I_r^2 + Q_r^2]^{3/2}}$$

for a set of N samples
where $I_I = \sin(\beta \cdot \sin(2 \cdot \pi \cdot f_m \cdot t))$ and
$Q_I = \cos(\beta \cdot \sin(2 \cdot \pi \cdot f_m \cdot t))$,
where $I_r$ and $Q_r$ are received FM modulated signal quadrature components, and
where $I_I$ and $Q_I$ are component values stored in a memory associated with the offset detector for a given received signal having a modulating frequency $f_m$ and modulation index $\beta$;

the frequency setter (222) is operable, in response to receipt of a signal from the estimator controller (203), to change the in-phase reference frequency by an amount which is substantially equal to one half of the value of the frequency $f_m$; and
the estimator controller (203) is operable to issue (409) a signal to the frequency setter (222) to change the in-phase reference frequency when a further integration time used by the offset detector has reached a pre-determined maximum value.

**11.** A receiver (200) according to claim 1, wherein the estimator controller (203) is operable to iteratively, over longer and longer integration time periods, temporarily suspend compensation for the receiver hardware induced component of DC offset and instead re-estimate the receiver hardware induced component of DC offset using the longer and longer integration time periods, until either it is determined that the re-calculated first parameter is equal to or less than the threshold value or it is determined (407) that a predetermined maximum integration value is reached, after which time the estimator controller (203) controls the estimator (202, 205) to compensate for the receiver hardware induced component of DC offset estimated over the predetermined maximum integration time period.

**Patentansprüche**

**1.** Empfänger (200) zum Empfangen und Demodulieren eines tonfrequenzmodulierten RF-Signals durch ein Direktumwandlungsverfahren, der umfasst: einen Eingangssignalpfad (101) zum Empfangen eines RF-Eingangssignals und, verbunden mit dem Eingangssignalpfad, Komponentenkanäle (103, 105) zum Verarbeiten von gleichphasigen (I) und um 90 Grad phasenverschobenen (Q) Komponenten des Eingangssignals;
wobei der Empfänger (200) weiterhin umfasst: einen Kompensator, der an einen der Komponentenkanäle (103, 105) gekoppelt ist und konfiguriert ist, um einen Gleichstrom-Offset zu messen und zu kompensieren, der durch die Empfängerhardware erzeugt wird, und mit einer Eingangssignalkomponente in dem entsprechenden Kanal kombiniert ist, wobei der Kompensator umfasst:

einen Schätzer (202, 205), der betriebsbereit ist, um eine empfängerhardwareinduzierte Komponente eines Gleichstrom-Offsets zu schätzen, die in dem einen der Komponentenkanäle (103, 105) vorkommt, unter Verwendung eines Integrationsverfahrens, berechnet über eine Integrationszeit; und
eine Schätzersteuerung (203), die betriebsbereit an den Schätzer (202, 205) gekoppelt ist und betriebsbereit ist, um:

(i) einen ersten Parameter, über einen Offset-Frequenzdetektor (223)-Anteil der Schätzersteuerung (203), als eine Umkehrfunktion einer bestimmten Offset-Frequenz zu berechnen, die zwischen einer Trägerfrequenz des RF-Eingangssignals und einem lokal erzeugten Referenzsignal vorkommt;
(ii) den ersten Parameter mit einem Schwellenwert zu vergleichen (404);
(iii) wenn der erste Parameter so groß wie oder kleiner als der Schwellenwert ist, den Schätzer (202, 205) zu steuern (406), um die empfängerhardwareinduzierte Komponente eines Gleichstrom-Offsets zu kompensieren, die über die Integrationszeit geschätzt wird; und
(iv) wenn der erste Parameter größer als der Schwellenwert ist, den Schätzer (202, 205) zu steuern, um vorübergehend eine Kompensation der empfängerhardwareinduzierten Komponente eines Gleichstrom-Offsets auszusetzen und stattdessen die empfängerhardwareinduzierte Komponente eines Gleichstrom-Offsets, unter Verwendung einer zweiten Integrationszeit, die länger als die Integrationszeit ist, neu zu schätzen.

**2.** Empfänger (200) gemäß Anspruch 1, wobei der Schätzer (202, 205) betriebsbereit ist, um die empfängerhardware-einduzierte Komponente des Gleichstrom-Offsets, die in einem der Komponentenkanäle vorkommt, folgendermaßen zu schätzen:

(i) Nehmen eines Satzes von N Abtastwerten des Wertes der Eingangssignalkomponente in dem einen von den Komponentenkanälen;
(ii) Summieren der für die N Abtastwerte erhaltenen Werte; und
(iii) Berechnen eines Mittelwertes durch Dividieren der Summe durch die Zahl N von Abtastwerten und wobei der Empfänger (200) weiterhin umfasst: einen Kombinator, der betriebsbereit ist, um mit der Eingangssignalkomponente ein Einstellsignal zu kombinieren, das die empfängerhardwareinduzierte Komponente des Gleichstrom-Offsets löscht, die in dem einen von den Komponentenkanälen vorkommt.

**3.** Empfänger (200) gemäß Anspruch 1 oder Anspruch 2, der weiterhin umfasst:

einen I-Kanal (103), der mit dem Eingangssignalpfad (101) verbunden ist, der umfasst: einen ersten Mischer (107) zum Mischen des RF-Eingangssignals mit einem gleichphasigen Referenzsignal, um eine gleichphasige Komponente ($I(t)$) des Eingangssignals in einem I-Kanal zu erzeugen;
einen Q-Kanal (105), der mit dem Eingangssignalpfad (101) verbunden ist, der umfasst: einen zweiten Mischer (109) zum Mischen des Eingangssignals mit einem um 90 Grad phasenverschobenen Referenzsignal, um eine um 90 Grad phasenverschobene Komponente ($Q(t)$) des Eingangssignals in dem Q-Kanal zu erzeugen;
einen I-Kanal-Kompensator zum Messen und Kompensieren einer empfängerhardwareinduzierten Komponente eines Gleichstrom-Offsets, die in dem I-Kanal vorkommt, die mit der Eingangssignalkomponente in dem I-Kanal kombiniert ist; und
einen Q-Kanal-Kompensator zum Messen und Kompensieren einer empfängerhardwareinduzierten Komponente eines Gleichstrom-Offsets, die in dem Q-Kanal vorkommt, die mit der Eingangssignalkomponente in dem Q-Kanal kombiniert ist.

**4.** Empfänger (200) gemäß Anspruch 3, wobei sowohl der I-Kanal-Kompensator als auch der Q-Kanal-Kompensator Schätzer (202, 205) umfassen, die betriebsbereit sind, um in einem gegebenen Satz von Abtastwerten eine selbe Zahl von N Abtastwerten von den Eingangssignalkomponenten zu nehmen.

**5.** Empfänger (200) gemäß Anspruch 4, wobei der Schätzer (202, 205) des I-Kanal-Kompensators und/oder des Q-Kanal-Kompensators betriebsbereit ist, um eine Zahl N von Abtastwerten in einem Satz von Abtastwerten zu nehmen, die von Satz zu Satz variable ist.

**6.** Empfänger (200) gemäß einem der vorangehenden Ansprüche, wobei:

die Schätzersteuerung (203) betriebsbereit ist, um die Integrationszeit zu steuern (408), die durch den Schätzer (202, 205) verwendet wird, um einen Satz von Werten von dem einen der Komponentenkanäle (103, 105) abzutasten; und
wobei der Offset-Frequenz-Detektor (223) betriebsbereit ist, wo bestimmt wird, dass eine Offset-Frequenz in einem Band liegt, das eine Frequenz k.*fm* umfasst, wo k Null oder eine ganze Zahl und *fm* eine Modulationsfrequenz des Eingangssignals ist, um den Schätzer zu veranlassen, ein Signal auszugeben, um eine Kompensation der empfängerhardwareinduzierten Komponente eines Gleichstrom-Offsets auszusetzen und stattdessen die empfängerhardwareinduzierte Komponente eines Gleichstrom-Offsets, unter Verwendung der zweiten Integrationszeit, die länger als die Integrationszeit ist, neu zu schätzen.

**7.** Empfänger (200) gemäß Anspruch 6, wobei
ein Wert des ersten Parameters *Int* gegeben wird durch:

$$Int = \frac{\left|\frac{1}{N}\sum_{n=0}^{N-1} I_r \cdot I_{\mathrm{I}}\right|^2 + \left|\frac{1}{N}\sum_{n=0}^{N-1} Q_r \cdot Q_{\mathrm{I}}\right|^2}{\left[I_r^2 + Q_r^2\right]^{3/2}}$$

für einen Satz von N Abtastwerten,
wobei $I_{\mathrm{I}} = \sin(\beta \cdot \sin(2 \cdot \pi \cdot f_m \cdot t))$ und
$Q_{\mathrm{I}} = \cos(\cdot \cdot \sin(2 \cdot \pi \cdot f_m \cdot t))$,
wobei $I_r$ und $Q_r$ empfangene FM-modulierte Signalquadraturkomponenten sind, und wobei $I_{\mathrm{I}}$ und $Q_{\mathrm{I}}$ Komponentenwerte sind, die in einem Speicher gespeichert sind, der mit dem Detektor verknüpft ist, für ein gegebenes empfangenes Signal, das über eine Modulationsfrequenz $f_m$ und einen Modulationsindex $\beta$ verfügt.

8. Empfänger (200) gemäß Anspruch 7, wobei die Schätzersteuerung (203) betriebsbereit ist, wenn der erste Parameter größer als der Schwellenwert ist, um den ersten Parameterwert nach der verlängerten Integrationszeit neu zu berechnen.

9. Empfänger (200) gemäß Anspruch 3, der weiterhin umfasst:

einen lokalen Oszillator (221) zum Erzeugen des Referenzsignals und einen Phasenschieber (113), der an den lokalen Oszillator (221) angeschlossen ist, zum Verschieben einer Phase des Referenzsignals, um das um 90 Grad phasenverschobene Referenzsignal zu erzeugen, und einen Frequenzeinsteller (222) zum Einstellen der Frequenz des Referenzsignals, das durch den lokalen Oszillator (221) erzeugt wird, wobei der Frequenzeinsteller (222) betriebsbereit ist, um die Frequenz des Referenzsignals zu verändern; und
die Schätzersteuerung (203), die betriebsbereit an den Frequenzeinsteller (222) gekoppelt ist, wobei der Offset-Detektor betriebsbereit ist, um den ersten Parameter als eine Umkehrfunktion einer bestimmten Offset-Frequenz zu berechnen, die zwischen der Trägerfrequenz des RF-Eingangssignals und dem Referenzsignal vorkommt, und wo bestimmt wird, dass eine Offset-Frequenz in einem Band liegt, das umfasst: eine Frequenz k.$fm$, wo k Null oder eine ganze Zahl ist, und $fm$ eine Modulationsfrequenz des Eingangssignals ist, und die Schätzersteuerung (203) betriebsbereit ist, um ein Signal an den Frequenzeinsteller auszugeben, um die Referenzfrequenz zu einer Frequenz zu verschieben, die außerhalb des Bandes liegt.

10. Empfänger (200) gemäß Anspruch 9, wobei
ein Wert des ersten Parameters $Int$ gegeben wird durch:

$$Int = \frac{\left|\frac{1}{N}\sum_{n=0}^{N-1} I_r \cdot I_{\mathrm{I}}\right|^2 + \left|\frac{1}{N}\sum_{n=0}^{N-1} Q_r \cdot Q_{\mathrm{I}}\right|^2}{\left[I_r^2 + Q_r^2\right]^{3/2}} .$$

für einen Satz von N Abtastwerten,
wobei $I_{\mathrm{I}} = \sin(\cdot \cdot \sin(2 \cdot \pi \cdot f_m \cdot t))$ und
$Q_{\mathrm{I}} = \cos(\cdot \sin(2 \cdot \pi \cdot f_m \cdot t))$,
wobei $I_r$ und $Q_r$ empfangene FM-modulierte Signalquadraturkomponenten sind, und
wobei $I_{\mathrm{I}}$ und $Q_{\mathrm{I}}$ Komponentenwerte sind, die in einem Speicher gespeichert sind, der mit dem Offset-Detektor verknüpft ist, für ein gegebenes empfangenes Signal, das über eine Modulationsfrequenz $f_m$ und einen Modulationsindex $\beta$ verfügt;
der Frequenzeinsteller (222), in Reaktion auf einen Empfang eines Signals von der Schätzersteuerung (203), betriebsbereit ist, um die gleichphasige Referenzfrequenz um einen Betrag zu ändern, der im Wesentlichen der Hälfte des Wertes der Frequenz $f_m$ entspricht; und
die Schätzersteuerung (203) betriebsbereit ist, um ein Signal an den Frequenzeinsteller (222) auszugeben (409), um die gleichphasige Referenzfrequenz zu ändern, wenn eine weitere Integrationszeit, die durch den Offset-Detektor verwendet wird, einen vorbestimmten Maximalwert erreicht hat.

**11.** Empfänger (200) gemäß Anspruch 1, wobei die Schätzersteuerung (203) betriebsbereit ist, um schrittweise, über immer längere Integrationszeiten, eine Kompensation des empfängerhardwareinduzierten Gleichstrom-Offsets zeitweise auszusetzen und stattdessen den empfängerhardwareinduzierten Gleichstrom-Offset, unter Verwendung von immer längeren Integrationszeiten, neu zu schätzen, bis entweder bestimmt ist, dass der neu berechnete erste Parameter genau so groß oder kleiner als der Schwellenwert ist, oder bestimmt ist (407), dass ein vorbestimmter maximaler Integrationswert erreicht ist, nach welcher Zeit die Schätzersteuerung (203) den Schätzer (202, 205) steuert, um die empfängerhardwareinduzierte Komponente eines Gleichstrom-Offsets zu kompensieren, der über die vorbestimmte maximale Integrationszeit geschätzt wird.

**Revendications**

**1.** Récepteur (200) destiné à recevoir et à démoduler un signal RF à modulation de fréquence audio, par le biais d'une procédure de conversion directe, incluant un chemin de signal d'entrée (101) pour recevoir un signal d'entrée RF et, connectés au chemin de signal d'entrée, des canaux à composantes (103, 105) pour traiter des composantes en phase (I) et des composantes de phase en quadrature (Q) du signal d'entrée ;
dans lequel le récepteur (200) comprend en outre un compensateur couplé à l'un des canaux à composantes (103, 105) et configuré de manière à mesurer et à compenser un décalage en courant continu produit par le matériel de récepteur et combiné avec une composante de signal d'entrée dans le canal respectif, le compensateur incluant :

un estimateur (202, 205) exploitable de manière à estimer une composante, induite par le matériel de récepteur, du décalage en courant continu présent dans l'un des canaux à composantes (103, 105), en faisant appel à une procédure d'intégration calculée sur une période de temps d'intégration ; et
un contrôleur d'estimateur (203) couplé de façon opérationnelle à l'estimateur (202, 205) et exploitable de manière à :

(i) calculer un premier paramètre, par l'intermédiaire d'une partie de détecteur de fréquence de décalage (223) du contrôleur d'estimateur (203), sous la forme d'une fonction inverse d'une fréquence de décalage déterminée présente entre une fréquence de porteuse du signal d'entrée RF et un signal de référence généré localement ;
(ii) comparer (404) le premier paramètre à une valeur seuil ;
(iii) si le premier paramètre est égal ou inférieur à la valeur seuil, commander (406) à l'estimateur (202, 205) de compenser la composante, induite par le matériel de récepteur, du décalage en courant continu, estimée sur la période de temps d'intégration ; et
(iv) si le premier paramètre est supérieur à la valeur seuil, commander à l'estimateur (202, 205) de suspendre temporairement la compensation de la composante, induite par le matériel de récepteur, du décalage en courant continu, et, à la place, d'estimer à nouveau la composante, induite par le matériel de récepteur, du décalage en courant continu, en utilisant une seconde période de temps d'intégration plus longue que la période de temps d'intégration.

**2.** Récepteur (200) selon la revendication 1, dans lequel l'estimateur (202, 205) est exploitable de manière à estimer la composante, induite par le matériel de récepteur, du décalage en courant continu, présente dans l'un des canaux à composantes, en :

(i) prélevant un ensemble de N échantillons de la valeur de la composante de signal d'entrée dans l'un des canaux à composantes ;
(ii) calculant la somme des valeurs obtenues pour les N échantillons ; et
(iii) calculant une valeur moyenne en divisant la somme par le nombre N d'échantillons ; et

dans lequel le récepteur (200) comprend en outre un combineur exploitable de manière à combiner, avec la composante de signal d'entrée, un signal d'ajustement qui annule la composante, induite par le matériel de récepteur, du décalage en courant continu, présente dans l'un des canaux à composantes.

**3.** Récepteur (200) selon la revendication 1 ou 2, comprenant en outre :

un canal I (103) connecté au chemin de signal d'entrée (101), incluant un premier mélangeur (107) pour mélanger le signal d'entrée RF avec un signal de référence en phase, en vue de produire une composante en phase (I *(t)*) du signal d'entrée dans un canal 1 ;

un canal Q (105) connecté au chemin de signal d'entrée (101), incluant un second mélangeur (109) pour mélanger le signal d'entrée avec un signal de référence de phase en quadrature, en vue de produire une composante de phase en quadrature (*Q(t)*) du signal d'entrée dans le canal Q ;

un compensateur de canal I pour mesurer et compenser une composante, induite par le matériel de récepteur, du décalage en courant continu, présente dans le canal I combiné avec la composante de signal d'entrée dans le canal 1 ; et

un compensateur de canal Q pour mesurer et compenser une composante, induite par le matériel de récepteur, du décalage en courant continu, présente dans le canal Q combiné avec la composante de signal d'entrée dans le canal Q.

4. Récepteur (200) selon la revendication 3, dans lequel le compensateur de canal I et le compensateur de canal Q comprennent chacun des estimateurs (202, 205) qui sont exploitables de manière à prélever un même nombre N d'échantillons des composantes de signal d'entrée, dans un ensemble d'échantillons donné.

5. Récepteur (200) selon la revendication 4, dans lequel l'estimateur (202, 205) d'au moins l'un parmi le compensateur de canal I et le compensateur de canal Q est exploitable de manière à prélever un nombre N d'échantillons dans un ensemble d'échantillons qui est variable d'un ensemble à l'autre.

6. Récepteur (200) selon l'une quelconque des revendications précédentes, dans lequel :

le contrôleur d'estimateur (203) est exploitable de manière à commander (408) la période de temps d'intégration utilisée par l'estimateur (202, 205) en vue d'échantillonner un ensemble de valeurs dudit un des canaux à composantes (103, 105) ; et

dans lequel le détecteur de fréquence de décalage (223) est exploitable, lorsqu'une fréquence de décalage est déterminée comme étant dans une bande qui inclut une fréquence k. *fm*, où k est égal à zéro ou est un nombre entier et *fm* est une fréquence de modulation du signal d'entrée, de manière à amener l'estimateur à émettre un signal destiné à suspendre la compensation de la composante, induite par le matériel de récepteur, du décalage en courant continu, et, à la place, à estimer à nouveau la composante, induite par le matériel de récepteur, du décalage en courant continu, en utilisant la seconde période de temps d'intégration plus longue que la période de temps d'intégration.

7. Récepteur (200) selon la revendication 6, dans lequel :

une valeur du premier paramètre *Int* est donnée par l'équation ci-dessous :

$$Int = \frac{|\frac{1}{N}\sum_{n=0}^{N-1} I_r \cdot I_I|^2 + |\frac{1}{N}\sum_{n=0}^{N-1} Q_r \cdot Q_I|^2}{[I_r^2 + Q_r^2]^{3/2}}$$

pour un ensemble de N échantillons,
où $I_I = \sin(\beta \cdot \sin(2 \cdot \pi \cdot f_m \cdot t))$ ; et
$Q_I = \cos(\beta \cdot \sin(2 \cdot \pi \cdot f_m \cdot t))$ ;
où $I_r$ et $Q_r$ sont des composantes en quadrature de signal à modulation FM reçues ; et
où $I_I$ et $Q_I$ sont des valeurs de composantes stockées dans une mémoire associée au détecteur, pour un signal donné reçu présentant une fréquence de modulation $f_m$ et un indice de modulation $\beta$.

8. Récepteur (200) selon la revendication 7, dans lequel le contrôleur d'estimateur (203) est exploitable, si le premier paramètre est supérieur à la valeur seuil, de manière à recalculer la première valeur de paramètre à l'issue du temps d'intégration augmenté.

9. Récepteur (200) selon la revendication 3, comprenant en outre :

un oscillateur local (221) destiné à produire le signal de référence, et un déphaseur (113), connecté à l'oscillateur local (221), destiné à déphaser le signal de référence, en vue de produire le signal de référence de phase en quadrature, et un module de définition de fréquence (222) destiné à définir la fréquence du signal de référence produit par l'oscillateur local (221), le module de définition de fréquence (222) étant exploitable de manière à modifier la fréquence du signal de référence ; et

le contrôleur d'estimateur (203) couplé de manière opérationnelle au module de définition de fréquence (222), le détecteur de décalage étant exploitable de manière à calculer le premier paramètre sous la forme d'une fonction inverse d'une fréquence de décalage déterminée présente entre la fréquence de porteuse du signal d'entrée RF et le signal de référence, et où une fréquence de décalage est déterminée comme étant située dans une bande qui inclut une fréquence k. *fm*, où k est égal à zéro ou est un nombre entier, et *fm* est une fréquence de modulation du signal d'entrée, et le contrôleur d'estimateur (203) est exploitable de manière à acheminer un signal vers le module de définition de fréquence en vue de décaler la fréquence de référence vers une fréquence hors de la bande.

10. Récepteur (200) selon la revendication 9, dans lequel :

une valeur du premier paramètre *Int* est donnée par l'équation ci-dessous :

$$Int = \frac{|\frac{1}{N}\sum_{n=0}^{N-1} I_r \cdot I_I|^2 + |\frac{1}{N}\sum_{n=0}^{N-1} Q_r \cdot Q_I|^2}{[I_r^2 + Q_r^2]^{3/2}}$$

pour un ensemble de N échantillons,
où $I_l = \sin(\beta \cdot \sin(2 \cdot \pi \cdot fm \cdot t))$ ; et
$Q_l = \cos(\beta \cdot \sin(2 \cdot \pi \cdot f_m \cdot t))$ ;
où $I_r$ et $Q_r$ sont des composantes en quadrature de signal à modulation FM reçues ; et
où $I_l$ et $Q_l$ sont des valeurs de composantes stockées dans une mémoire associée au détecteur de décalage, pour un signal donné reçu présentant une fréquence de modulation $f_m$ et un indice de modulation $\beta$ ;

le module de définition de fréquence (222) est exploitable, en réponse à la réception d'un signal provenant du contrôleur d'estimateur (203), de manière à modifier la fréquence de référence en phase d'une quantité qui est sensiblement égale à une moitié de la valeur de la fréquence $f_m$ ; et

le contrôleur d'estimateur (203) est exploitable de manière à acheminer (409) un signal vers le module de définition de fréquence (222) en vue de modifier la fréquence de référence en phase lorsqu'un temps d'intégration supplémentaire utilisé par le détecteur de décalage a atteint une valeur maximale prédéterminée.

11. Récepteur (200) selon la revendication 1, dans lequel le contrôleur d'estimateur (203) est exploitable, de manière itérative, sur des périodes de temps d'intégration de plus en plus longues, de manière à suspendre temporairement la compensation de la composante, induite par le matériel de récepteur, du décalage en courant continu, et, à la place, à estimer à nouveau la composante, induite par le matériel de récepteur, du décalage en courant continu, en utilisant les périodes de temps d'intégration de plus en plus longues, jusqu'à ce qu'il soit déterminé que le premier paramètre recalculé est égal ou inférieur à la valeur seuil, ou qu'il soit déterminé (407) qu'une valeur d'intégration maximale prédéterminée est atteinte, après quoi le contrôleur d'estimateur (203) commande à l'estimateur (202, 205) de compenser la composante, induite par le matériel de récepteur, du décalage en courant continu, estimée sur la période de temps d'intégration maximale prédéterminée.

*100*

DC_I

I(t)

LOW PASS
FILTER

I'(t)

107

2COS(wt)

LOCAL
OSCILLATOR

111

103

101

x(t)

PHASE
SHIFTER

113

105

2SIN(wt)

Q(t)

LOW PASS
FILTER

Q'(t)

109

DC_Q

*FIG. 1*

*FIG. 2*

*FIG. 3*

*400*

RECEIVE I AND Q
SAMPLES 401

SET DC
INTEGRATION TIME
TO 200 msec 402

INCREASE DC
INTEGRATION TIME
BY 200 msec 408

CALCULATE
DC_I_est
DC_Q_est 403

DETECTOR
OUTPUT>THR 404

INTEGRATION
TIME>2000 msec 407

NO

YES

YES

NO

RELEASE
DC_I_est
DC_Q_est 405

SHIFT LO
REFERENCE
FREQUENCY 409

APPLY DC_I_est
DC_Q_est
CORRECTION 406

FIG. 4

**EP 1 869 779 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6608999 B
- US 20040014450 A
- GB 0411888 A
- GB 0414459 A